(19) Europäisches Patentamt / European Patent Office / Office européen des brevets

(11) **EP 4 671 418 A1**

(12) **EUROPEAN PATENT APPLICATION**
published in accordance with Art. 153(4) EPC

(43) Date of publication:
**31.12.2025  Bulletin 2026/01**

(21) Application number: **24760459.8**

(22) Date of filing: **26.02.2024**

(51) International Patent Classification (IPC):
**C30B 13/20** *(2006.01)*

(52) Cooperative Patent Classification (CPC):
**C30B 13/20**

(86) International application number:
**PCT/JP2024/006896**

(87) International publication number:
**WO 2024/177161 (29.08.2024 Gazette 2024/35)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **26.02.2023   JP 2023027869**

(71) Applicants:
• **C & A Corporation**
  **Sendai-shi, Miyagi 980-0811 (JP)**
• **Tohoku University**
  **Sendai-shi, Miyagi 980-8577 (JP)**

(72) Inventors:
• **Tomida, Taketoshi**
  **Sendai-shi, Miyagi 980-0811 (JP)**

• **Takahashi, Isao**
  **Sendai-shi, Miyagi 980-0811 (JP)**
• **Kochurikhin, Vladimir**
  **Sendai-shi, Miyagi 980-0811 (JP)**
• **Gushchina, Liudmila**
  **Sendai-shi, Miyagi 980-0811 (JP)**
• **Kakimoto, Koichi**
  **Sendai-shi, Miyagi 980-8577 (JP)**
• **Shoji, Yasuhiro**
  **Sendai-shi, Miyagi 980-0811 (JP)**
• **Yoshikawa, Akira**
  **Sendai-shi, Miyagi 980-8577 (JP)**
• **Kamada, Kei**
  **Sendai-shi, Miyagi 980-8577 (JP)**

(74) Representative: **Maiwald GmbH**
  **Elisenhof**
  **Elisenstraße 3**
  **80335 München (DE)**

(54) **PRODUCTION DEVICE AND PRODUCTION METHOD**

(57)     [Problem] To provide a production device and a production method capable of producing a crystal in an industrially advantageous manner.

[Solution] A production device for a crystal, including at least a high-frequency induction-heating coil, the production device being configured to form a molten zone of a raw material solution by using high-frequency induction heating, and produce a crystal by crystal growth in a longitudinal direction of the molten zone, wherein a width of the molten zone satisfies the following Formula (1):

wherein D represents the width (cm) of the molten zone, p represents a resistivity ($\mu\Omega$cm) of the raw material solution, $\mu$ represents a relative permeability of the raw material solution, and F represents a frequency (Hz) of the high-frequency induction-heating coil.

$$\frac{D}{2} > 5.03\sqrt{\rho/\mu F} \quad \cdots (1)$$

EP 4 671 418 A1

**Description**

Technical Field

The present invention relates to a crystal production device and a production method for a crystal.

Background Art

For the construction of the next generation digital infrastructure, energy saving of power devices that perform power conversion, such as home appliances, electric vehicles, industrial machines, and renewable energy, is required. Conventionally, power devices using silicon have been the mainstream, but there is a demand for a power semiconductor material having a smaller energy conversion loss than silicon. As such materials, silicon carbide (SiC), gallium nitride (GaN), gallium oxide, and the like have been researched and developed.

At present, for example, an Edge-Defined Filmfed Growth (EFG) method is known as a technique for growing a single crystal of gallium oxide, and is disclosed in Patent Document 1 and Non-Patent Document 1. Although a stable crystal is obtained by using the EFG method, the crystal is not satisfactory in crystallinity and growth rate.

In addition, a skull melt method of growing a single crystal by directly applying an electromagnetic field to a base material to be crystal-grown by an induction coil has been researched and developed, and Patent Documents 2 and 3 disclose a cold crucible suitable for the skull melt method and an example of producing a single crystal using the cold crucible. Further, Patent Document 4 discloses a cold crucible of gallium oxide and a method for producing a single crystal of gallium oxide by the skull melt method using the cold crucible, and Patent Document 5 discloses a configuration of an apparatus for producing a single crystal by the skull melt method. However, the techniques described in Patent Document 1 and Non-Patent Document 1 still have a problem that it is difficult to reduce the cost because the crucible needs to be large in order to increase the size of the crystal and the crucible material that can be used at the melting point of gallium oxide is an expensive material such as iridium. In addition, Patent Documents 2 to 5 do not disclose specific production conditions of the single crystal. Furthermore, although research and development of crystal growth by the skull melt method have been conducted, there are still many problems for industrial mass production and commercialization, and therefore, a measure capable of realizing industrially favorable crystal growth has been awaited.

Citation List

Patent Literature

Patent Document 1: JP 2006-312571 A
Patent Document 2: US 4049384 A
Patent Document 3: JP S60-2876 A
Patent Document 4: JP 2017-61396 A
Patent Document 5: JP 2018-191426 A

Non-Patent Document

Non-Patent Document 1: Hideo Aida et al., Growth of β-Ga2O3 single crystals by the Edge-Defined, Film Fed Growth Method, Jpn. Journal of Applied Physics, Vol. 47, No. 11, 2008, pp. 8506-8509

Summary of Invention

Technical Problem

An object of the present invention is to provide a production device and a production method capable of producing a crystal in an industrially advantageous manner.

Solution to Problem

As a result of intensive studies to achieve the above object, and with the finding that when forming a molten zone of a raw material solution by using high-frequency induction heating with a high-frequency induction-heating coil, and producing a crystal by crystal growth in a longitudinal direction of the molten zone, crystal growth can be efficiently and favorably performed by controlling the physical properties of the material, the width of the molten zone, and the frequency, the present inventors have found that such a production method and a production device can solve the above conventional problems at once.

Further, after obtaining the above findings, the present inventors have further conducted studies and completed the present invention.

That is, the present invention relates to the following invention.

[1] A production device for a crystal, including at least a high-frequency induction-heating coil, the production device being configured to form a molten zone of a raw material solution by using high-frequency induction heating, and produce a crystal by crystal growth in a longitudinal direction of the molten zone, wherein a width of the molten zone satisfies the following Formula (1):
[Formula 1]

$$\delta = 5.03 \times (\rho / (\mu \times F))\,1/2 \quad \cdots \text{Formula (4)}$$

wherein D represents the width (cm) of the molten zone, $\rho$ represents a resistivity ($\mu\Omega$cm) of the raw material solution, $\mu$ represents a relative permeability of the raw material solution, and F represents a frequency (Hz) of the high-frequency induction-heating coil.

[2] The production device according to [1], wherein an upper end of the high-frequency induction-heating coil is disposed at a depth position of 5 mm or less from a liquid surface of the raw material melt, and the production device includes a positional relationship holding unit that performs the crystal growth while maintaining a positional relationship between the depth position and the upper end.

[3] The production device according to [2], wherein the positional relationship holding unit includes a movable unit for the high-frequency induction-heating coil or a movable unit for the molten zone.

[4] The production device according to [1], further including a cold container used in a skull melt method, wherein the width of the molten zone is an inner dimension of the cold container, and the crystal growth is performed by a melt growth method using a melt directly heated by high frequency waves.

[5] The production device according to [1], wherein the raw material solution contains Ga.

[6] A production method for a crystal, the method forming a molten zone of a raw material solution by using high-frequency induction heating with a high-frequency induction-heating coil, and producing a crystal by crystal growth in a longitudinal direction of the molten zone, wherein the crystal growth is performed so as to satisfy Formula (1) below:
[Formula 2]

$$\delta = 5.03 \times (\rho / (\mu \times F))\,1/2 \quad \cdots \text{Formula (4)}$$

wherein D represents the width (cm) of the molten zone, $\rho$ represents a resistivity ($\mu\Omega$cm) of the raw material solution, $\mu$ represents a relative permeability of the raw material solution, and F represents a frequency (Hz) of the high-frequency induction-heating coil.

[7] The production method according to [6], wherein an upper end of the high-frequency induction-heating coil is disposed at a depth position of 5 mm or less from a liquid surface of the raw material melt, and the crystal growth is performed while maintaining a positional relationship between the depth position and the upper end.

[8] The production method according to [7], wherein the crystal growth is performed while moving the high-frequency induction-heating coil or the molten zone.

[9] The production method according to [6], wherein the crystal growth is performed by a melt growth method using a melt directly heated by high frequency waves.

[10] The production method according to [6], wherein the raw material solution contains Ga.

Advantageous Effects of Invention

According to the production device and the production method of the present invention, crystals can be produced in an industrially advantageous manner.

Brief Description of Drawings

FIG. 1 is a flowchart for explaining a crystal growth method according to Embodiment 1 of the present invention.

# EP 4 671 418 A1

FIG. 2A is a configuration diagram illustrating a configuration of a crystal growth device according to Embodiment 1 of the present invention.

FIG. 2B is a configuration diagram illustrating the configuration of the crystal growth device according to Embodiment 1 of the present invention.

FIG. 2C is a configuration diagram illustrating the configuration of the crystal growth device according to Embodiment 1 of the present invention.

FIG. 2D is a configuration diagram illustrating the configuration of the crystal growth device according to Embodiment 1 of the present invention.

FIG. 2E is a configuration diagram illustrating the configuration of the crystal growth device according to Embodiment 1 of the present invention.

FIG. 3 is a flowchart for explaining a crystal growth method according to Embodiment 2 of the present invention.

FIG. 4A is a configuration diagram illustrating a configuration of a crystal growth device according to Embodiment 2 of the present invention.

FIG. 4B is a configuration diagram illustrating the configuration of the crystal growth device according to Embodiment 2 of the present invention.

FIG. 4C is a configuration diagram illustrating the configuration of the crystal growth device according to Embodiment 2 of the present invention.

FIG. 4D is a configuration diagram illustrating the configuration of the crystal growth device according to Embodiment 2 of the present invention.

FIG. 5 is a flowchart for explaining a method of controlling the crystal diameter of the raw material in the crystal growth method according to the embodiment of the present invention.

FIG. 6 is a configuration diagram illustrating a configuration of a crystal diameter control mechanism in the crystal growth device according to the embodiment of the present invention.

FIG. 7 is a configuration diagram of a high-frequency heating device according to the embodiment of the present invention.

FIG. 8(A) is a schematic circuit diagram of an inverter unit, and FIG. 8(B) is a schematic diagram of high frequency waves generated by a transistor.

FIG. 9 is a diagram schematically illustrating a circuit including a part of the circuit of the inverter unit and an LCR circuit including a heating coil in the embodiment.

FIG. 10(A) is a conceptual diagram for explaining a phase difference between an output current waveform and a reference waveform, and FIG. 10(B) is a waveform diagram illustrating an example of the output current waveform and an output voltage waveform.

FIG. 11 is a graph showing changes over time in a drive frequency, phase difference, current, and voltage when the frequency is controlled by the phase difference in a crystal growth step in the crystal production method according to the embodiment of the present invention.

FIG. 12 is a graph showing the phase difference, drive frequency, current, and voltage when the frequency is controlled by the phase difference in a melting step in the crystal production method according to the embodiment of the present invention.

FIG. 13 is a graph showing the phase difference, drive frequency, current, and voltage when the frequency is controlled by the phase difference in the crystal growth step in the crystal production method according to the embodiment of the present invention.

FIG. 14 is a diagram showing the results of temperature distribution calculation of a preferred embodiment of the present invention.

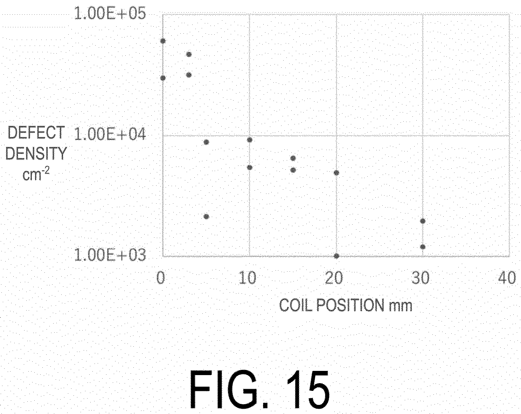

FIG. 15 is a diagram showing the relationship between a coil position and crystal defect density, and showing improvement of the crystallinity of the present invention.

Description of Embodiments

A production device of the present invention includes at least a high-frequency induction-heating coil, the production device being configured to form a molten zone of a raw material solution by using high-frequency induction heating, and produce a crystal by crystal growth in a longitudinal direction of the molten zone, wherein a width of the molten zone satisfies the following Formula (1):
[Formula 3]

$$\frac{D}{2} > 5.03\sqrt{\rho/\mu F} \quad \cdots (1)$$

wherein D represents the width (cm) of the molten zone, $\rho$ represents a resistivity ($\mu\Omega$cm) of the raw material solution, $\mu$ represents a relative permeability of the raw material solution, and F represents a frequency (Hz) of the high-frequency induction-heating coil.

In the present invention, an upper end of the high-frequency induction-heating coil is preferably disposed at a depth position of 5 mm or less from a liquid surface of the raw material melt, and the production device preferably includes a positional relationship holding unit that performs the crystal growth while maintaining a positional relationship between the depth position and the upper end. More preferably, the positional relationship holding unit includes a movable unit for the high-frequency induction-heating coil. According to such a preferred range, crystal growth can be more easily performed. The positional relationship holding unit and the movable unit are not particularly limited as long as the object of the present invention is not inhibited, and known units may be used for the positional relationship holding unit and the movable unit.

In addition, in the present invention, a cold container used in a skull melt method is preferably further included, the width of the molten zone is preferably an inner dimension of the cold container, and the crystal growth is preferably performed by a melt growth method using a melt directly heated by high frequency waves, since this enables better crystal growth without the use of a crucible.

In the present invention, the raw material solution preferably contains Ga, because a Ga-containing crystal such as gallium oxide is more easily obtained by the crystal growth.

Further, a production method of the present invention is a method forming a molten zone of a raw material solution by using high-frequency induction heating with a high-frequency induction-heating coil, and producing a crystal by crystal growth in a longitudinal direction of the molten zone, wherein the crystal growth is performed so as to satisfy the above-described Formula (1).

In the present invention, an upper end of the high-frequency induction-heating coil is preferably disposed at a depth position of 5 mm or less from a liquid surface of the raw material melt, and the crystal growth is preferably performed while maintaining a positional relationship between the depth position and the upper end, and more preferably, the crystal growth is performed while moving the high-frequency induction-heating coil. According to such a preferred range, crystal growth can be more easily performed.

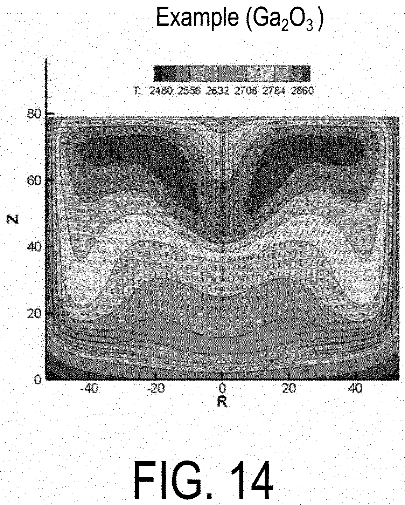

The results of temperature distribution calculation of the above-described preferred embodiment of the present invention are shown in FIG. 14. The temperature distribution diagram of FIG. 14 shows a temperature distribution when crystal growth is performed by a melt growth method using a melt obtained by directly heating gallium oxide with high frequency waves. As is clear from FIG. 14, the temperature gradient in the solution zone is a temperature gradient projecting downward that facilitates crystal growth, and it is understood that the preferred embodiment of the present invention is more suitable for crystal growth. Such findings are new findings obtained for the first time by the present inventors.

Hereinafter, preferred embodiments of the present invention will be described in more detail with reference to the drawings, but the present invention is not limited to these specific examples.

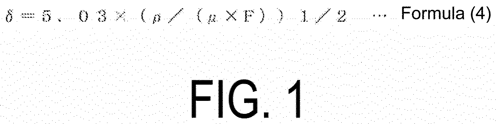

Description will be made with reference to FIG. 1. According to a preferred crystal growth method, a single crystal of a raw material such as zirconium oxide, titanium, titanium aluminum alloy, iron oxide, magnesium oxide, calcium oxide, strontium oxide, yttrium oxide, chromium oxide, lanthanum chromium oxide, strontium titanate, gadolinium oxide, scandium oxide, lutetium oxide, lanthanum nickel oxide, gallium oxide, aluminum oxide, magnesium aluminum oxide, yttrium aluminum garnet, gadolinium aluminum gallium garnet, lanthanum gadolinium silicon oxide, strontium iodide, cerium bromide, lithium calcium aluminum fluoride, lithium tantalate, or lithium niobate can be obtained by crystal growth.

First, in a first step S101, a central portion of a raw material body at one end side of the raw material body is heated by induction heating and melted while the periphery of the raw material body made of a solid material is cooled. At this time, a metal that easily absorbs a magnetic field can be used as a starter for initial heating, and the influence of contamination can be reduced by using a metal element contained in the raw material body. When the raw material body is liquefied by heat generation in the starter, the resistivity is greatly lowered, resulting in better absorption of the magnetic field and the formation of a stable molten zone. For example, in the case of gallium oxide, examples of the starter include Ir, Ga metal, and the like.

The raw material body may have, for example, a cylindrical shape. The raw material body may be, for example, a cylinder with a bottom surface diameter of 100 mm and a height of 100 mm. The raw material body is disposed so that the other end side (lower surface) of the raw material body is on the ground side and the axis of the cylinder is orthogonal to the ground.

Next, in a second step S102, a seed crystal is brought into contact with a melted body at the central portion of one end side (upper surface) of the raw material body. By heating as described above, the central portion of the one end side of the raw material body is formed into the melted body in which the raw material is melted, and the seed crystal is brought into contact with the upper surface of the melted body. In this step as well, the frequency of the induction heating is kept within a range shifted from the resonance frequency of the melted body, and the temperature gradient of the melted body as described above is maintained. This temperature gradient control is maintained in the subsequent steps described below.

Next, in a third step S103, while the periphery of the raw material body is cooled, the portion to be heated by induction heating is moved from one end side to the other end side of the raw material body, and the portion where the raw material is melted in the central portion of the raw material body is moved from one end side to the other end side of the raw material body. Here, the above-described movement is performed from one end side of the raw material body to the other end side of the raw material body disposed on the ground side. By this movement, a crystal of the raw material is grown from the portion with which the seed crystal is in contact, in the direction from the one end side to the other end side of the raw material body. At this time, the seed crystal may be pulled up at a constant speed. When the Cz method is used as the crystal growth means, it is preferable to perform pulling.

Here, at least in the second step S102 and the third step S103 described above, the central portion of the raw material body is heated by induction heating within a range in which the frequency of the induction heating is shifted from the resonance frequency of the melted body, so that the temperature is lower toward the central portion of the raw material body (temperature gradient of the melted body) in a plane perpendicular to the direction from one end side to the other end side of the raw material body. In this way, by changing the frequency of the induction heating in a range shifted from the resonance frequency of the melted body and controlling the temperature gradient of the melted body in the plane, the diameter of the crystal of the raw material can be controlled. However, this is not necessarily required in the present invention, and such a control means can be used as appropriate, and other control means (for example, a means for changing the magnetic field output, a means for changing the coil position, or the like) can also be suitably used.

In the case where the raw material is an oxide, the second step S102 and the third step S103 can be performed in an atmosphere having an oxygen concentration of 10% or more by volume. The oxygen concentration is more preferably 50% or more, and still more preferably 80% or more.

Here, by varying the concentration of the dopant impurity added to the raw material body in the direction from one end side to the other end side of the raw material body, the impurity concentration can be made uniform over the entire region in the direction of crystal growth. Further, in the third step S103, at least one of the seed crystal and the raw material body can be rotated about an axis oriented in the movement direction.

The dopant to be added may be silicon, germanium, tin, iron, lithium, magnesium, or chromium in the case of gallium oxide, for example. In the case of an oxide or an ionic crystal, cerium, europium, ytterbium, neodymium, terbium, erbium, holmium, thulium, or praseodymium can be added as the dopant.

When the seed crystal is pulled up, the grown crystal is separated from the melt, and then the heating is gradually stopped to solidify the raw material body.

Alternatively, after the crystal of the raw material is grown from the portion with which the seed crystal is in contact to a predetermined portion in the direction from one end side to the other end side of the raw material body, the heating is stopped, and the melted body inside the raw material body is slowly cooled and solidified. As a result, a single crystal of the raw material is formed inside the raw material body by crystal growth from the seed crystal. Thereafter, by removing the raw material around the raw material body, the single crystal of the raw material is taken out.

According to the above-described embodiment, the peripheral portion of the raw material body that is cooled and maintained in a solid state serves as a crucible that accommodates the melted body. Therefore, the problem of impurity contamination from the crucible does not occur. In addition, since it is not necessary to use a crucible made of a costly material, the manufacturing cost is suppressed. Further, by lowering an upper end of the coil by 5 mm or more from a top surface of the solution, a state in which the temperature is lower toward the central portion of the raw material body in a plane perpendicular to the direction from one end side to the other end side of the raw material body is maintained, and therefore, a high-quality crystal can be produced.

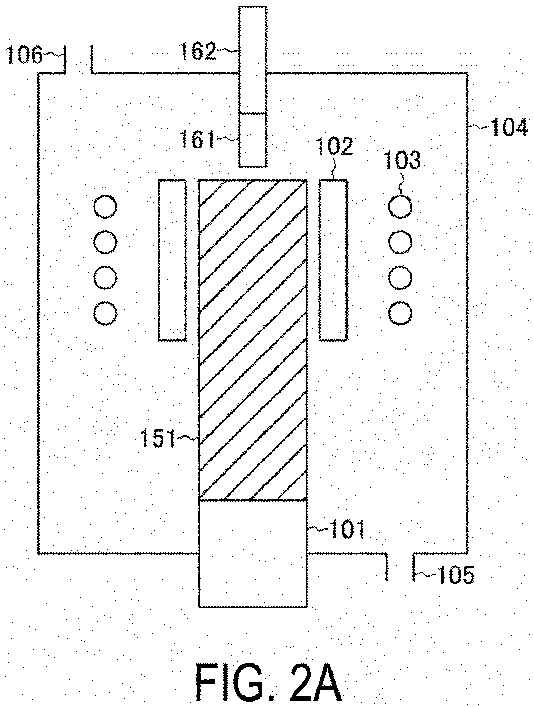

Next, a crystal growth device for implementing the crystal growth method according to the above-described embodiment will be described with reference to FIGS. 2A to 2E. The crystal growth device is a device for growing an oxide crystal, an ion bonding type crystal, or the like, and includes a holding table 101, a cooling mechanism 102, and a high-frequency induction-heating coil 103. Further, a growth chamber 104 that accommodates the holding table 101, the cooling mechanism 102, and the high-frequency induction-heating coil 103 is included.

The holding table 101 is made of a solid raw material and holds a raw material body 151. The raw material body 151 is, for example, a cylinder. The raw material body 151 is disposed on the holding table 101 such that the other end side (lower surface) of the raw material body 151 is on the ground side and the axis of the cylinder is perpendicular to the ground. A seed crystal 161 is disposed on one end side (upper surface) of the raw material body 151. In addition, in Embodiment 1, a holding rod 162 that holds the seed crystal 161 is provided. The seed crystal 161 is formed of a crystal made of the same material as the raw material body, or an oxide crystal, an ion bonding type crystal, or a covalent bonding type crystal.

The cooling mechanism 102 is disposed in a state of covering the peripheral surface of the raw material body 151 held by the holding table 101, and cools the raw material body 151. The cooling mechanism 102 is formed of, for example, a copper pipe through which a cooling medium flows, and the copper pipe is arranged in a state where a coiled, wavy, or U-shaped pipe is bundled. Further, the cooling mechanism 102 is provided with a mechanism which covers the entire raw material body 151 from the upper end to the lower end in the crystal growth direction or which moves simultaneously with the high-frequency induction-heating coil 103.

The high-frequency induction-heating coil 103 is disposed to surround the cooling mechanism 102. The high-frequency induction-heating coil 103 constitutes a heating mechanism for heating, by high-frequency induction heating, the raw material body 151 at a portion covered with the cooling mechanism 102. The heating mechanism includes a mechanism (not illustrated) that applies a frequency of induction heating to the high-frequency induction-heating coil 103, the frequency being shifted from the resonance frequency of the melted body of the raw material body.

When the region of the raw material body 151 cooled by the cooling mechanism 102 is heated to, for example, 1000°C by the heating mechanism by the high-frequency induction-heating coil 103, the central portion of the raw material body 151 becomes a melted body in which the raw material is melted. On the other hand, the peripheral portion of the raw material body 151 around this region is cooled by the cooling mechanism 102, and therefore maintains the solid state. In this state, the peripheral portion of the raw material body 151, which is cooled by the cooling mechanism 102 and maintained in a solid state, serves as a crucible for accommodating a melted body 152.

The growth chamber 104 includes an exhaust pipe 105 and a gas introduction pipe 106. An exhaust mechanism (not illustrated) for exhausting the inside of the growth chamber 104 is connected to the exhaust pipe 105. The gas introduction pipe 106 is provided with a gas introduction mechanism (not illustrated) that introduces a gas containing oxygen into the growth chamber 104. After the inside of the growth chamber 104 is evacuated by the exhaust mechanism, for example, an oxygen gas having an oxygen concentration of 10% or more by volume or a mixed gas of a carbon dioxide gas and an inert gas such as an argon gas or a nitrogen gas is introduced by the gas introduction mechanism, whereby the oxygen concentration in the growth chamber 104 can be 10% or more by volume.

The crystal growth device also includes a moving mechanism (not illustrated) that moves the cooling mechanism 102 and the high-frequency induction-heating coil 103 relative to the raw material body 151 from one end side to the other end side of the raw material body 151. First, the cooling mechanism 102 and the high-frequency induction-heating coil 103 are disposed on one end side (upper surface side) of the raw material body 151, and the cooling mechanism 102 and the heating mechanism are operated, whereby the second step S102 can be performed. Further, in this state, the moving mechanism is operated to move (lower) the cooling mechanism 102 and the high-frequency induction-heating coil 103 toward the other end side (downward), whereby the third step S103 can be performed.

Further, a moving mechanism (not illustrated) that moves the holding rod 162 in a direction in which the seed crystal 161 is separated from the raw material body 151 side may be provided. The device may further include a rotation mechanism (not illustrated) that rotates the seed crystal 161 and the raw material body 151 in different directions about an axis oriented in the movement direction by the moving mechanism.

Using this crystal growth device, first, as illustrated in FIG. 2A, the raw material body 151 is fixed on the holding table 101. For example, Y2O3, Al2O3, and CeO2 powders are mixed in a molar ratio of 3: 5: 0.015, sintered, and the resulting raw material powder is filled into a water-cooled hearth with an inner diameter (diameter) of 150 mm inside the cooling mechanism 102, thereby forming the raw material body 151 with a diameter of 150 mm. In addition, metal aluminum is disposed in the raw material body 151. The water-cooled hearth is fixed on the holding table 101.

Further, the seed crystal 161 made of a single crystal of yttrium aluminum garnet (YAG) is held by the holding rod 162 in a state of being separated from one end side of the raw material body 151. Further, the moving mechanism (not illustrated) is controlled to dispose the cooling mechanism 102 and the high-frequency induction-heating coil 103 on one end side (upper portion) of the raw material body 151.

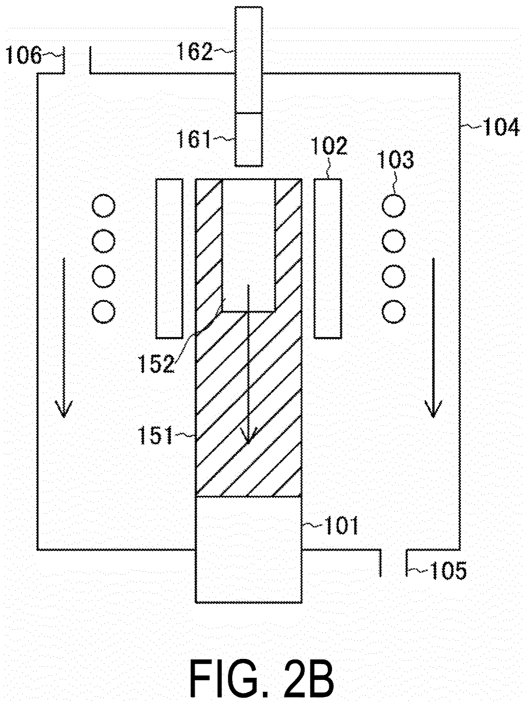

In the above state, the growth chamber 104 is sealed, and the cooling mechanism 102 and the high-frequency induction-heating coil 103 are operated, thereby heating and melting the metallic aluminum in the raw material body 151 on one end side of the raw material body 151 by induction heating using a high-frequency wave of 1 MHz, as illustrated in FIG. 2B. A melted body of the metal aluminum, which is melted by induction heating, is used as a heat source to melt the raw material powder constituting the raw material body 151, whereby the melted body (melted body) 152 having a diameter of 140 mm is obtained. The resonance frequency of the melted body 152 in this example is the 1 MHz.

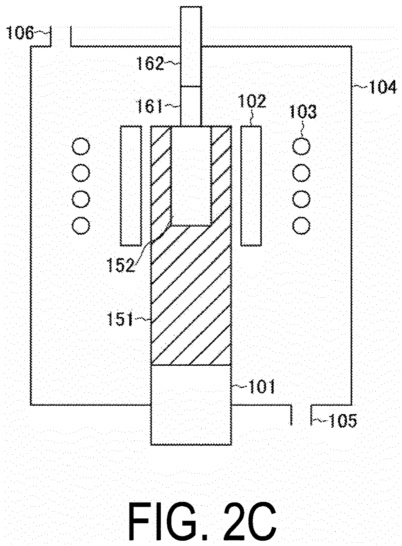

Next, while controlling the frequency of the high-frequency wave applied to the high-frequency induction-heating coil 103 within a range of 0.8 to 1. 2 MHz, the holding rod 162 is lowered as illustrated in FIG. 2C, thereby bringing a lower end of the seed crystal 161 into contact with an upper surface of the melted body 152 formed in the central portion of one end side (upper surface) of the raw material body 151.

In a state where an alternating current flows through the melted body 152, which is a conductor, as the frequency of the alternating current increases, the current concentrates on the surface of the melted body 152 (the current density increases), and the current becomes less likely to flow (the current density decreases) toward the center of the melted body 152 (skin effect). By adjusting the frequency applied to the high-frequency induction-heating coil 103 with respect to the resonance frequency of the melted body 152, the heating efficiency of the region where the skin effect penetrates is controlled, and the temperature gradient within the plane of the melted body 152 is optimized.

In the above-described control of the applied frequency, since the resonance frequency changes with changes in the temperature of the melted body 152 and the melting region, the resonance frequency of the melted body 152 is measured in real time, and the applied frequency is controlled so that the phase difference between the applied frequency and the measured resonance frequency becomes constant.

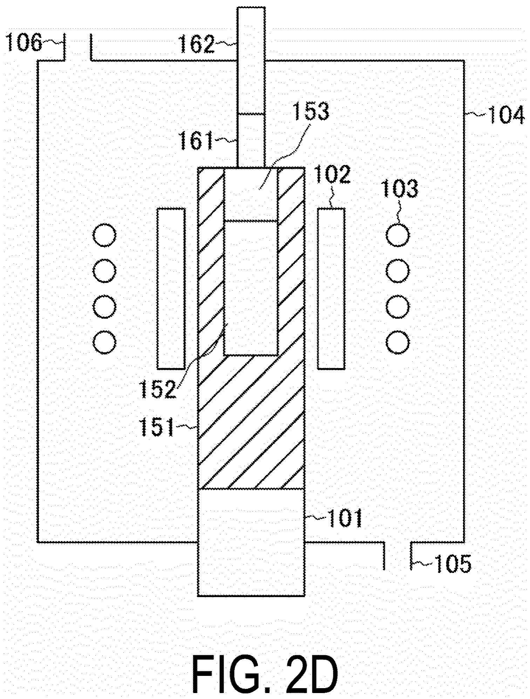

As described above, from the state where the temperature gradient within the plane of the melted body 152 is optimized, the moving mechanism (not illustrated) is controlled to move (lower) the cooling mechanism 102 and the high-frequency induction-heating coil 103 toward the other end side, thereby moving the portion to be heated by induction heating from one end side to the other end side of the raw material body 151, and moving the melted body 152, in which the raw material in the central portion of the raw material body 151 is melted, from one end side to the other end side of the raw material body 151. As a result, as illustrated in FIG. 2D, the one end side of the raw material body 151 in contact with the seed crystal 161 is not heated, and the temperature thereof decreases.

As the temperature decreases, a crystal 153 of the raw material grows from the portion with which the seed crystal 161 is in contact in the direction from the one end side to the other end side of the raw material body 151. As a result, a yellow transparent Ce-doped $Y_3Al_5O_{12}$ crystal 153 having a diameter of 100 mm was obtained.

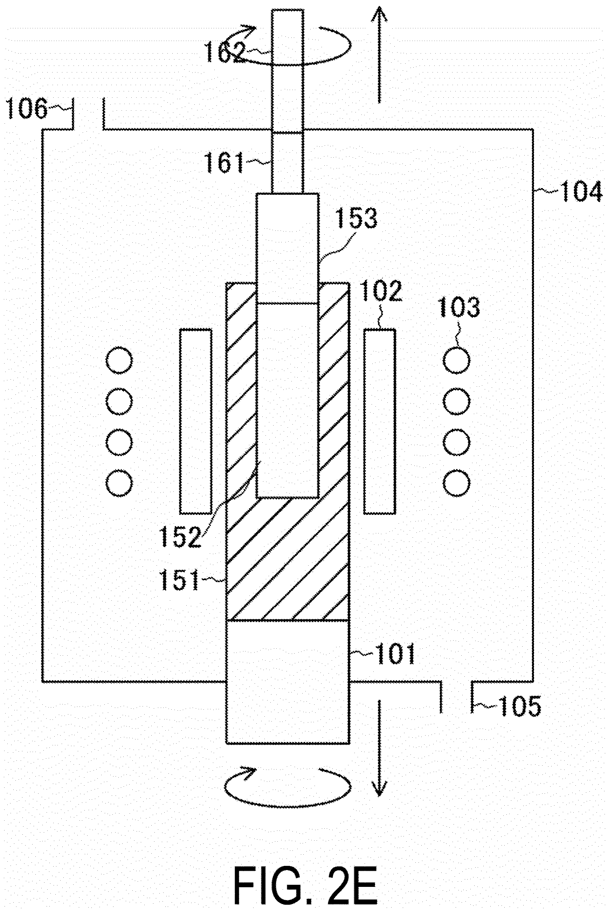

Further, as a fourth step, as illustrated in FIG. 2E, the seed crystal 161 is pulled up with rotation in the direction of being separated from the melted body 151 while the periphery of the raw material body 151 is cooled by the cooling mechanism 102, or the melted body 151 is pulled down with rotation toward the ground in the direction of being separated from the seed crystal 161 together with the cooling mechanism 102 and the high-frequency induction-heating coil 103. This movement allows the crystal 153 of the raw material to grow from the portion with which the seed crystal 161 is in contact in the direction from the one end side to the other end side of the raw material body 151.

As described above, after the crystal 153 is grown from the position where the seed crystal 161 is brought into contact with and pulling is started until the length of the straight body reaches the set length, the crystal 153 is cut off and slowly cooled, and then heating is stopped. After sufficient cooling, the crystal 153 is taken out.

Embodiment 2

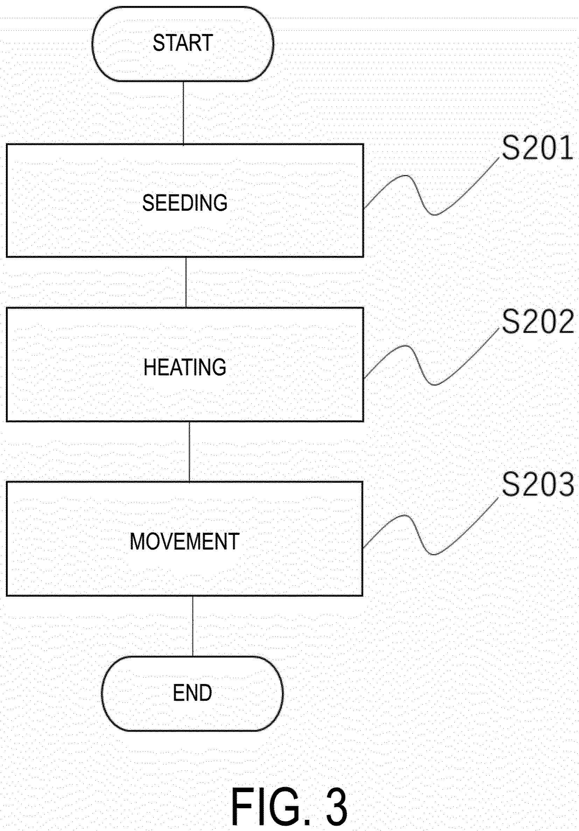

Next, a crystal growth method according to Embodiment 2 of the present invention will be described with reference to FIG. 3. First, in a first step S201, a seed crystal is brought into contact with one end side of a raw material body made of a solid material. The raw material body may have, for example, a cylindrical shape. The raw material body is arranged so that an axis of the cylinder is perpendicular to the ground with one end side (lower surface) of the raw material body as the ground side, and the seed crystal is embedded in the raw material body in the vicinity of the other end side (upper surface) of the raw material body.

Next, in a second step S202, while the periphery of the raw material body is cooled, the central portion of the raw material body in the vicinity of the region of the raw material body where the seed crystal is brought into contact (embedded) is heated and melted by induction-heating using high-frequency waves. Thus, the central portion of the raw material body is a melted body in which the raw material is melted, and the periphery of the raw material body and the other end side of the raw material body are maintained in a solid state. The melted body is then brought into contact with the seed crystal by enlarging the melting portion. In this state, the peripheral portion of the raw material body which is cooled and maintained in a solid state serves as a crucible that accommodates the melted body. Therefore, the problem of impurity contamination from the crucible does not occur. In addition, since it is not necessary to use a crucible made of a costly material, the manufacturing cost is suppressed.

Next, in a third step S203, while the periphery of the raw material body is cooled, the portion to be heated by the induction heating is moved from one end side to the other end side of the raw material body, and the portion where the raw material is melted in the central portion of the raw material body is moved from one end side to the other end side of the raw material body. Here, the above-described movement is performed from one end side (lower surface side) of the raw material body disposed on the ground side to the other end side (upper surface side) of the raw material body. By this movement, the crystal of the raw material is grown from the portion with which the seed crystal is in contact in the direction from the one end side to the other end side of the raw material body. In the case where the raw material is an oxide, the second step S202 and the third step S203 can be performed in an atmosphere having an oxygen concentration of 10% or more by volume.

Here, at least in the second step S102 and the third step S103 described above, the central portion of the raw material body is heated by induction heating within a range in which the frequency of the induction heating is shifted from the resonance frequency of the melted body, so that the temperature is lower toward the central portion of the raw material body (temperature gradient of the melted body) in a plane perpendicular to the direction from one end side to the other end side of the raw material body. In this way, by changing the frequency of the induction heating in a range shifted from the resonance frequency of the melted body and controlling the temperature gradient within the plane of the melted body, the diameter of the crystal of the raw material can be controlled.

By varying the concentration of the dopant impurity added to the raw material body in the direction from one end side to the other end side of the raw material body, the concentration of the dopant impurity in the crystal being grown can be made uniform over the entire region in the direction of crystal growth as described above.

As described above, after the crystal of the raw material is grown from the portion with which the seed crystal is in contact to a predetermined portion in the direction from one end side to the other end side of the raw material body, the heating is stopped, and the melted body inside the raw material body is slowly cooled and solidified. As a result, a single crystal of the raw material is formed inside the raw material body by crystal growth from the seed crystal. Thereafter, by removing the raw material around the raw material body, the single crystal of the raw material is taken out.

According to the above-described embodiment, the peripheral portion of the raw material body that is cooled and maintained in a solid state serves as a crucible that accommodates the melted body. Therefore, the problem of impurity contamination from the crucible does not occur. In addition, since it is not necessary to use a crucible made of a costly material, the manufacturing cost is suppressed. In addition, since a state in which the temperature is lower toward the central portion of the raw material body in a plane perpendicular to the direction from one end side to the other end side of the raw material body is maintained, the region of the melted body for crystal growth can be made larger.

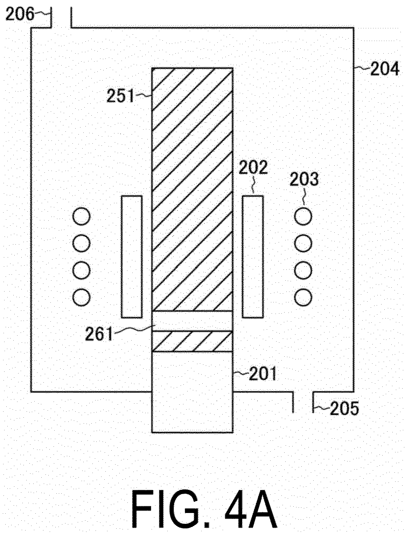

Next, a crystal growth device for implementing the crystal growth method according to the above-described embodiment will be described with reference to FIGS. 4A to 4D. The crystal growth device is a device for growing an oxide crystal, an ion bonding type crystal, or the like, and includes a holding table 201, a cooling mechanism 202, and a high-frequency induction-heating coil 203. Further, a growth chamber 204 that accommodates the holding table 201, the cooling mechanism 202, and the high-frequency induction-heating coil 203 is included.

The holding table 201 is made of a solid raw material and holds a raw material body 251. A seed crystal 261 is embedded in one end side of a raw material body 251. The raw material body 251 is, for example, a cylinder with a bottom surface diameter of 60 mm and a height of 50 mm. The raw material body 251 is disposed on the holding table 201 such that the one end side (lower surface) of the raw material body 251 is on the ground side and the axis of the cylinder is perpendicular to the ground. The seed crystal 261 is embedded in the raw material body 251 on one end side (lower surface) side of the raw material body 251. The seed crystal 261 is formed of a crystal made of the same material as the raw material body, an oxide crystal, an ion bonding type crystal, or a covalent bonding type crystal.

The cooling mechanism 202 is disposed in a state of covering the peripheral surface of the raw material body 251 held by the holding table 201, and cools the raw material body 251. The cooling mechanism 202 is formed of, for example, a copper pipe through which a cooling medium flows, and the copper pipe is arranged in a state where a coiled, wavy, or U-shaped pipe is bundled. Further, the cooling mechanism 202 is provided with a mechanism which covers the entire raw material body 251 from the upper end to the lower end in the crystal growth direction or moves simultaneously with the high-frequency induction-heating coil 203.

The high-frequency induction-heating coil 203 is disposed to surround the cooling mechanism 202. The high-frequency induction-heating coil 203 constitutes a heating mechanism for heating, by high-frequency induction heating, the raw material body 251 at a portion covered with the cooling mechanism 202. The heating mechanism includes a mechanism (not illustrated) that applies a frequency of induction heating to the high-frequency induction-heating coil 203, the frequency being shifted from the resonance frequency of the melted body of the raw material body.

When the region of the raw material body 251 cooled by the cooling mechanism 202 is heated to, for example, 2000°C by the heating mechanism by the high-frequency induction-heating coil 203, the central portion of the raw material body 251 becomes a melted body 252 in which the raw material is melted. On the other hand, the peripheral portion of the raw material body 251 around this region is cooled by the cooling mechanism 202, and therefore maintains a solid state. In this state, the peripheral portion of the raw material body 251, which is cooled by the cooling mechanism 202 and maintained in a solid state, serves as a crucible for accommodating the melted body 252.

The growth chamber 204 includes an exhaust pipe 205 and a gas introduction pipe 206. An exhaust mechanism (not illustrated) for exhausting the inside of the growth chamber 204 is connected to the exhaust pipe 205. The gas introduction pipe 206 is provided with a gas introduction mechanism (not illustrated) that introduces a gas containing oxygen into the growth chamber 204. After the inside of the growth chamber 204 is evacuated by the exhaust mechanism, for example, a mixed gas of an oxygen gas having an oxygen concentration of 50% or more by volume and an inert gas such as an argon gas is introduced by the gas introduction mechanism, whereby the oxygen concentration in the growth chamber 204 can be 10% or more by volume.

Further, the crystal growth device also includes a moving mechanism (not illustrated) that moves the cooling mechanism 202 and the high-frequency induction-heating coil 203 relative to the raw material body 251 from one end side to the other end side of the raw material body 251. First, the cooling mechanism 202 and the high-frequency induction-heating coil 203 are disposed on one end side (lower surface side) of the raw material body 251, and the cooling mechanism 202 and the heating mechanism are operated, whereby the second step S202 can be performed. Further, in this state, the moving mechanism is operated to move (raise) the cooling mechanism 202 and the high-frequency induction-heating coil 203 toward the other end side (upward), whereby the third step S203 can be performed.

Using this crystal growth device, first, as illustrated in FIG. 4A, the raw material body 251 having the seed crystal 261 embedded in one end side (lower portion) thereof is fixed on the holding table 201. For example, $Gd_2O_3$, $Ga_2O_3$, $Al_2O_3$, and $CeO_2$ powders are mixed in a molar ratio of 3: 3: 2: 0.015, sintered, and the resulting raw material powder is filled into a water-cooled hearth with an inner diameter of 150 mm inside the cooling mechanism 102, thereby forming the raw material body 251 with a diameter of 150 mm. In addition, metal gallium (Ga) is provided in the raw material body 251. The water-cooled hearth is fixed on the holding table 201.

Further, the seed crystal 261 made of a $Gd_3Ga_3Al_2O_{12}$ single crystal was disposed at the bottom of the raw material body 251. In this example, the seed crystal 261 has a diameter of, for example, 150 mm, which is the same as that of the raw material body 251.

Further, the moving mechanism (not illustrated) is controlled to dispose the cooling mechanism 202 and the high-frequency induction-heating coil 203 on one end side (lower portion) of the raw material body 251.

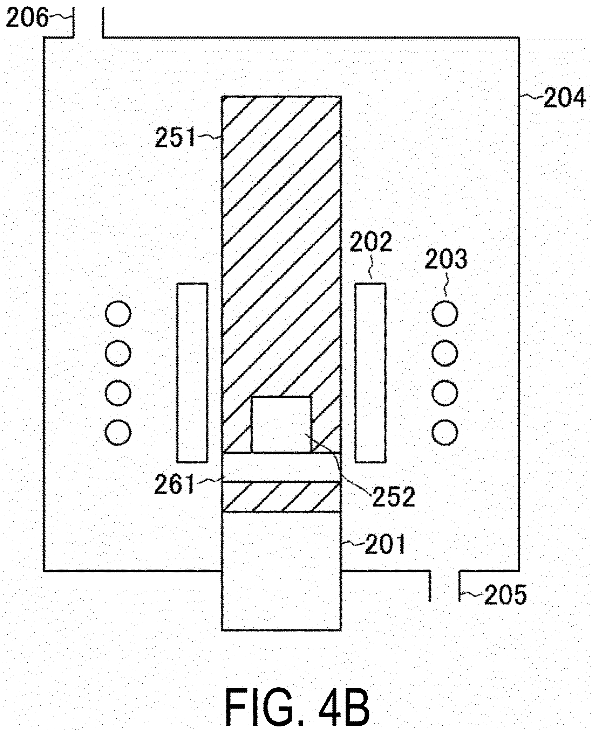

Next, the cooling mechanism 202 and the high-frequency induction-heating coil 203 are operated, thereby heating and melting the metallic gallium in the raw material body 251 on one end side of the raw material body 251 by induction heating using a high frequency of 0.5 MHz, as illustrated in FIG. 4B. A melted body of the metal gallium, which is melted by induction heating, is used as a heat source to melt the raw material powder constituting the raw material body 251, whereby the melted body 252 having a diameter of 140 mm is obtained. The resonance frequency of the melted body 252 in this example is 0.45 MHz.

Next, the frequency of the high-frequency wave applied to the high-frequency induction-heating coil 203 is controlled within the range of 0.2 to 0.5 MHz. In a state where an alternating current flows through the melted body 252, which is a conductor, as the frequency of the alternating current increases, the current concentrates on the surface of the melted body 252 (the current density increases), and the current becomes less likely to flow (the current density decreases) toward the center of the melted body 252 (skin effect). By adjusting the frequency applied to the high-frequency induction-heating coil 203 with respect to the resonance frequency of the melted body 252, the heating efficiency of the region where the skin effect penetrates is controlled, and the temperature gradient within the plane of the melted body 252 is optimized. Although the amount of the formed melted body 252 changes by controlling the applied voltage and current, the temperature distribution within the plane cannot be optimized.

In the above-described control of the applied frequency, since the resonance frequency changes with changes in the temperature of the melted body 252 and the melting region, the resonance frequency of the melted body 252 is measured in real time, and the applied frequency is controlled so that the phase difference between the applied frequency and the measured resonance frequency becomes constant.

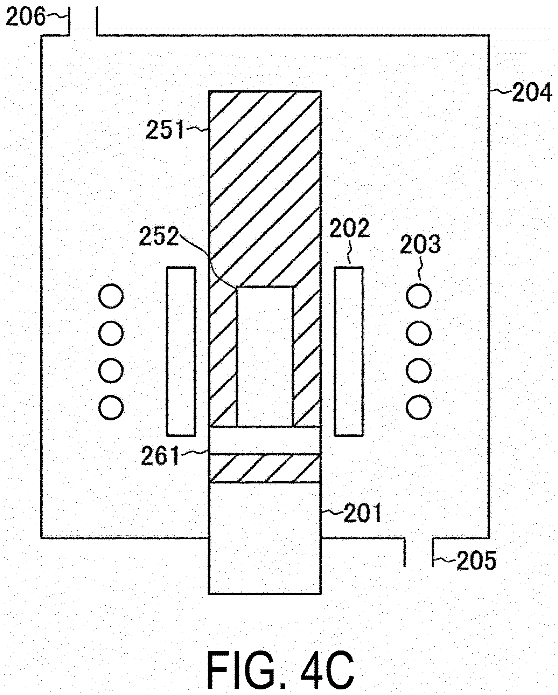

As described above, when the heating with the temperature gradient within the plane of the melted body 252 optimized is continued, the region where the melted body 252 is formed spreads upward as illustrated in FIG. 4C. The lower end of the melted body 252 is in contact with the seed crystal 261. From this state, the moving mechanism (not illustrated) is controlled to move (raise) the cooling mechanism 202 and the high-frequency induction-heating coil 203 toward the other end side, thereby moving the portion to be heated by induction heating from one end side to the other end side of the raw material body 251, and moving the melted body 252, in which the raw material in the central portion of the raw material body 251 is melted, from one end side to the other end side of the raw material body 251.

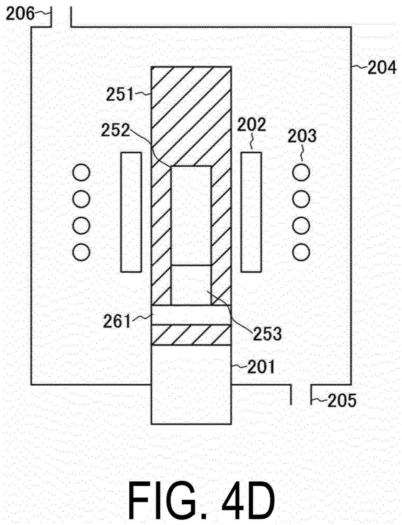

As a result, as illustrated in FIG. 4D, the one end side of the raw material body 251 in contact with the seed crystal 261 is not heated, and the temperature thereof decreases. As the temperature decreases, a crystal 253 of the raw material grows from the portion with which the seed crystal 261 is in contact in the direction from the one end side to the other end side of the raw material body 251. As a result, a yellow transparent Ce-doped Gd3Ga3Al2O12 crystal 253 having a diameter of 100 mm was obtained.

Next, control of the crystal diameter in the crystal growth method and device according to the embodiment of the present invention will be described. In the third step, by changing the frequency of the high-frequency induction heating in a range shifted from the resonance frequency of the melted body, the temperature gradient within the plane of the melted body is controlled, and the diameter of the crystal of the raw material can be controlled.

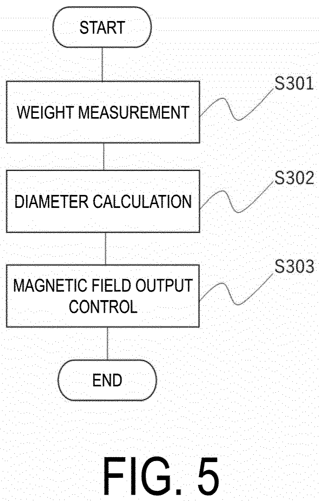

More specifically, as illustrated in FIG. 5, the third step includes a weight-measuring step S301, a diameter-calculating step S302, and a magnetic-field-output controlling step S303.

The weight-measuring step S301 measures the weight of the grown crystal at a set period. In the diameter-calculating step S302, the diameter is calculated from the crystal density and the seed crystal pulling speed (crystal growth rate) based on the weight measured in the weight-measuring step S301. In the magnetic-field-output controlling step S303, the output and frequency of the magnetic field applied to the coil are controlled so as to eliminate the difference between the diameters calculated in the diameter-calculating step S302 and a set reference value.

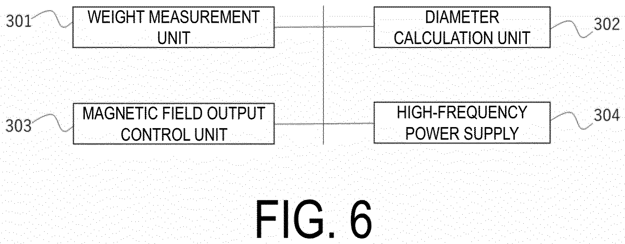

The crystal growth device according to the embodiment of the present invention may include a crystal diameter control mechanism for performing the above-described method of controlling the crystal diameter. As illustrated in FIG. 6, the crystal diameter control mechanism includes a weight measurement unit 301, a diameter calculation unit 302, and a magnetic field output control unit 303.

The weight measurement unit 301 measures the weight of the raw material crystal that is grown using the seed crystal at a set period. The weight measurement unit 301 can be configured by, for example, a load cell. The load cell can be provided, for example, on a holding rod that holds the seed crystal.

The diameter calculation unit 302 calculates the diameter of the crystal grown during the first period from the crystal density and the distance by which the crystal is pulled up during the first period, based on the weight measured by the weight measurement unit 301. The magnetic field output control unit 303 controls the power and frequency of the current output from a high-frequency power supply 304 to the high-frequency induction-heating coil for the high-frequency induction heating so as to eliminate the difference between the diameter calculated by the diameter calculation unit 302 and the set reference value. In this way, by using the measurement result of the weight of the growing crystal, and controlling the power and frequency of the current applied to the high-frequency induction-heating coil, an automatic diameter control system that controls the diameter of the growing crystal can be configured.

The diameter calculation unit 302 and the magnetic field output control unit 303 of the crystal diameter control mechanism according to the above-described embodiment may be computer equipment including a central processing unit (CPU), a main storage device, an external storage device, a network connection device, and the like, and the CPU may operate (execute a program) by a program deployed in the main storage device to realize each of the above-described functions (the method for controlling the crystal diameter). The above program is a program for causing a computer to execute the crystal diameter control method described in the above-described embodiment. The network connection device is connected to a network. In addition, each function can be distributed to a plurality of computer devices.

The materials grown by the method of the present invention are gallium oxide, sapphire, gadolinium-aluminum-gallium garnet, lithium tantalate, lithium niobate, yttrium oxide, and yttrium aluminum garnet, and it was found that the materials have good crystallinity when the magnetic field frequency is controlled to be from 400 kHz to 5 MHz and the width of the molten zone is controlled to be from 50 mm to 150 mm.

A high-frequency heating device preferably used in the present invention will be described below with reference to the drawings.

High-Frequency Heating Device 1

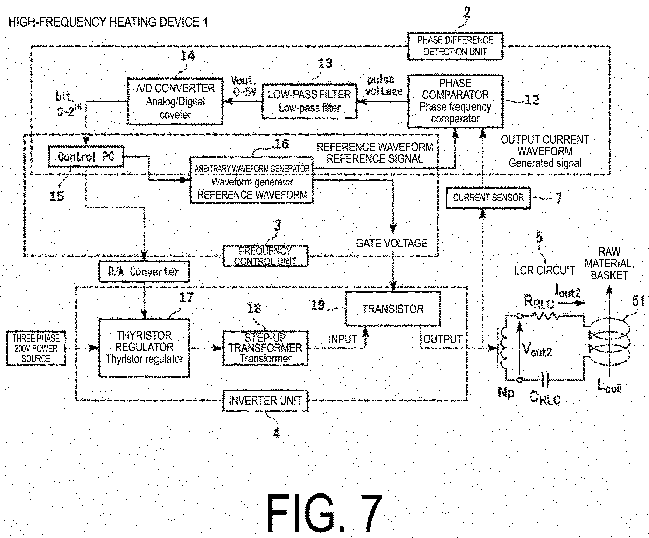

A high-frequency heating device 1 according to an embodiment of the present invention will be described with reference to FIG. 7. In the present invention, not only the semiconductor-type heating device illustrated in FIG. 7 but also a vacuum tube-type heating device can be suitably used. FIG. 7 is a configuration diagram of a high-frequency heating device according to the present embodiment. The high-frequency heating device 1 according to the present embodiment includes at least a phase difference detection unit 2, a frequency control unit 3, an inverter unit 4, and an LCR circuit 5.

Phase Difference Detection Unit 2

The phase difference detection unit 2 detects a phase difference between the high-frequency voltage generated by the frequency control unit 3 and the high-frequency current flowing through the LCR circuit 5. The phase difference here is, as illustrated in FIG. 1, a difference between the phase of the voltage of the reference waveform applied to the gate of the transistor 19 and the phase of the operating current. This phase difference also coincides with the difference between the phase of the operating voltage and the phase of the operating current, which are the output of a transistor 19 switched by the reference waveform input to the gate of the transistor 19. Therefore, the phase difference detection unit 2 detects a difference between the phase of the voltage of the reference waveform applied to the gate of the transistor 19 and the phase of the operating current, or a difference between the phase of the operating voltage and the phase of the operating current of the transistor 19. As illustrated in FIG. 1, the phase difference detection unit 2 includes at least a phase comparator 12, a low-pass filter 13, and an A/D converter 14, and includes a part of a computer 15.

Phase Comparator 12

The phase comparator 12 detects a phase difference between two input signals. Specifically, the phase comparator 12 converts a phase difference between an output current waveform of the LCR circuit 5 and a reference waveform generated by an arbitrary waveform generator 16 into a voltage and outputs the voltage as an error signal.

Low-Pass Filter 13

The low-pass filter 13 smooths the error signal (pulse) corresponding to the phase difference output by the phase comparator 102, and outputs the smoothed error signal as a DC voltage. The low-pass filter 13 outputs, for example, the DC voltage of 0 to 5 V. The low-pass filter 13 is sometimes called a loop filter.

A/D Converter 14

The A/D converter 14 converts the DC voltage output by the low-pass filter 103 into a digital signal.

Computer 15

The computer 15 detects a difference between a phase of the voltage of the reference waveform applied to the gate of the transistor 19, which is described later, and a phase of an operating current, or a difference (phase difference) between a phase of an operating voltage of the transistor 19 and a phase of the operating current, compares the difference with a set threshold value, and when the difference crosses the threshold value (changes from a value exceeding the threshold value to a value less than the threshold value, or changes from a value less than the threshold value to a value exceeding the threshold value), increases or decreases the drive frequency by a preset change width, thereby updating the drive frequency, and inputs a control signal for generating the updated drive frequency to the arbitrary waveform generator 16. Further, the computer 15 compares the detected phase difference with the set threshold value, and when the phase difference crosses the threshold value, updates the drive frequency by a certain frequency variation amount, and inputs a signal for generating the updated drive frequency to the arbitrary waveform generator 16. The certain frequency variation amount may be a width obtained in advance from actual manufacturing conditions. The threshold value of the phase difference mentioned here is a threshold value when the drive frequency is brought close to the resonance frequency by a certain frequency variation amount, and there are two threshold values of an upper limit threshold value and a lower limit threshold value in the threshold value. In the feedback control, when the phase difference becomes larger than the set value of the phase difference, the set value of the phase difference is set as the upper limit threshold value of the phase difference. When the phase difference becomes smaller than the set phase value, the drive frequency is moved away from the resonance frequency by a certain frequency variation amount. The value of the phase difference set at this time is set as the lower limit threshold value of the phase difference. The upper limit threshold value and the lower limit threshold value are collectively referred to as phase difference threshold values. The frequency variation amount refers to an amount by which the drive frequency is changed when the phase difference deviates from the set threshold value of the phase difference.

Frequency Control Unit 3

As illustrated in FIG. 7, the frequency control unit 3 includes at least the arbitrary waveform generator 16, and includes a part of the computer 15. The frequency control unit 3 generates a waveform (frequency pulse) arbitrarily set by the computer 15 and the arbitrary waveform generator 16.

Arbitrary Waveform Generator 16

The arbitrary waveform generator 16 generates a reference waveform. The arbitrary waveform generator 16 generates a waveform of the drive frequency updated by the control signal input from the computer 15 and outputs the waveform to the gate of the transistor 19. At the same time, the waveform is output to the phase comparator 12 as a reference signal. The arbitrary waveform generator 16 generates a frequency pulse based on the phase difference detected by the phase difference detection unit 2. The computer 15 controls the transistor 19 with the updated frequency pulse, and generates a high-frequency voltage with the updated drive frequency to be applied to the LCR circuit 5.

Inverter Unit 4

The inverter unit 4 generates a high-frequency voltage. The high-frequency voltage generated by the inverter unit 4 drives the LCR circuit 5. As a result, a high-frequency current flows from the LCR circuit 5 to the heating coil 51, and the raw material is heated. As illustrated in FIG. 1, the inverter unit 4 includes at least a thyristor regulator 17, a step-up transformer 18, and a plurality of transistors 19.

Thyristor Regulator 17

The thyristor regulator 17 controls the alternating current output from a power supply.

Step-up Transformer 18

The step-up transformer 18 increases the voltage output from the power supply.

Transistor 19

The transistor 19 operates as a switching element. The transistor 19 applies a high-frequency voltage of the drive frequency to the LCR circuit 5. The transistor 19 is preferably made of SiC. The transistor preferably has the structure of a metal-oxide-semiconductor field-effect transistor (MOSFET), a metal-semiconductor field-effect-transistor (MESFET), or an insulated gate bipolar transistor (IGBT).

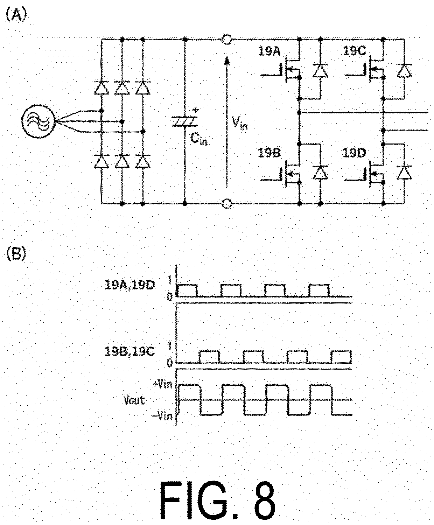

FIG. 8(A) is a schematic circuit diagram of the inverter unit, and FIG. 8(B) is a schematic diagram of high frequency waves generated by the transistor. As illustrated in FIG. 8(A), the inverter unit 4 includes a plurality of transistors 109 in parallel. The inverter unit 4 rectifies the three phase current output from the thyristor regulator 17 with a bridge diode, stores electric charge in a capacitor, and causes the current to flow from the capacitor to the plurality of transistors 109 as a direct current (AC/DC conversion). Thus, the voltage (gate voltage) corresponding to the charge stored in each transistor 19 is applied, and the transistor 19 functions as a switching element. Frequency control is performed by applying a high-frequency waveform generated by the arbitrary waveform generator 106 in response to the frequency control signal output from the computer 15 to the gate of the transistor 19, thereby controlling the gate voltage. When the gate voltage exceeds a threshold voltage Vth of the transistor 19, the transistor 19 is turned on. In the inverter circuit illustrated in FIG. 8(A), a transistor 19A and a transistor 109D are combined, and a transistor 19B and a transistor 19C are combined, so that a rectangular wave for turning on and off is formed. As illustrated in FIG. 8(B), by controlling the gate voltage of each transistor 19, the frequency of an output voltage Vout is controlled. By the above-described frequency control, the transistor 19 outputs a frequency (drive frequency) of a rectangular wave in a range of several hundred kHz to the 10 MHz order. The drive frequency output from the transistor 19 is preferably 20 MHz or less, for example. This makes it possible to melt a raw material having a higher melting point. The drive frequency output from the transistor 19 is more preferably 10 MHz or less, and further preferably 6 MHz or less. The drive frequency output from the transistor 19 is preferably 100 kHz or more, and more preferably 300 kHz or more. The duty of the rectangular wave can be adjusted, but here, a rectangular wave with a duty of 40% is generated.

The transistor 19 is preferably made of SiC. In the case of SiC, high voltage resistance can be achieved, and switching loss and series resistance loss can be reduced, so that the frequency can be controlled with higher output and more precisely, and the temperature distribution can be controlled precisely even in a raw material having a high melting point. Further, as described above, since a wide range of frequencies can be realized, the frequency can be adjusted according to the size of the melt, the temperature dependence of the resistivity, and the resistivity difference between the solid and the liquid.

LCR Circuit 5

The LCR circuit 5 is a circuit (LCR series circuit) in which a coil, a capacitor, and a resistor are connected in series. The LCR circuit 5 includes the heating coil 51. The heating coil 51 corresponds to a coil in the LCR circuit. The LCR circuit 5 removes the harmonic component of the rectangular wave to form a sinusoidal current of a fundamental wave.

An induced current generated in the LCR circuit 5 by a high-frequency current generated by the high-frequency heating device 1 flows through the heating coil 51, and a magnetic field is generated around the heating coil 51. Inside the heating coil 51, the raw material disposed inside a basket (not illustrated) contains a conductive material, and induction heating starts from the conductive material. An eddy current flows through the raw material in a direction that prevents a change in the magnetic field which changes in response to a change in the high-frequency current, and Joule heat is generated due to the electrical resistance of the raw material, thereby heating the raw material and the temperature is controlled.

The combined impedance of the LCR series circuit is expressed by the following Formula (2).

[Formula 4]

$$\dot{Z} = R + j\left(\omega L - \frac{1}{\omega C}\right) \qquad \cdots \quad \text{Formula (2)}$$

In Formula (2),

$\dot{Z}$ is the combined impedance ($\Omega$),
R is the impedance of the resistor ($\Omega$),
$j\omega L$ is the impedance of the coil ($\Omega$), and
$1/\omega C$ is the impedance of the capacitor ($\Omega$).

In the Formula (2), ωL is also referred to as inductive reactance XL, and 1/ωC is also referred to as capacitive reactance XC. Here, since a frequency f = ω/2π, the inductive reactance XL and the capacitive reactance XC change as the frequency f changes. As a result, a phase difference (phase angle) θ between the alternating voltage and the alternating current changes. For example, when the inductive reactance XL is larger or smaller than the capacitive reactance XC, the phase angle θ is expressed by the following Formula (3). When the inductive reactance XL and the capacitive reactance XC are equal to each other, the phase angle θ is 0.

[Formula 5]

$$\theta = \tan^{-1}\left(\frac{\omega L - \dfrac{1}{\omega C}}{R}\right) \quad \cdots \quad \text{Formula (3)}$$

As described above, when the frequency of the output voltage of the transistor is updated, the phase difference θ between the high-frequency voltage and the high-frequency current changes, and the high-frequency voltage and the high-frequency current applied to the heating coil 51 change. Therefore, the heating efficiency of the raw material changes, and the temperature distribution of the raw material changes.

In the case of using the skull melt method to directly heat the raw material by induction heating and grow a crystal, the convection state of the melt of the raw material, in other words, the temperature distribution of the melt is extremely important.

Here, when a magnetic field is applied to a melt having conductivity, eddy currents are generated in the melt, inducing a magnetic field that cancels out the applied magnetic field. Therefore, a penetration depth δ of the applied magnetic field follows an Formula (4) using a resistivity ρ of the melt, a relative permeability μ of the melt, and the frequency f.

[Formula 6]

$$\delta = 5.03 \times (\rho / (\mu \times F))\, 1/2 \quad \cdots \quad \text{Formula (4)}$$

As shown in the Formula (4), since the penetration depth δ of the magnetic field depends on the frequency f, in order to optimally control the temperature distribution of the melt by changing the penetration depth δ of the magnetic field, it is important to design the entire system and to design the resonance frequency and the drive frequency band of the system in consideration of the size of the basket and the heating coil to be used.

For example, when the frequency is low and the magnetic field penetrates deeply into the melt, the temperature of the raw material melt near the center of the melt where the seed crystal is disposed becomes the melting point or more, and crystal growth does not progress. On the other hand, by increasing the frequency and reducing the penetration depth of the magnetic field, the temperature of the raw material melt in the vicinity of the seed crystal becomes lower than the melting point, and the crystal growth can be progressed.

Current Sensor 7

The high-frequency heating device 1 according to the present embodiment may include a current sensor 7. The current sensor 7 measures the amplitude and frequency of the alternating current output from the transistor 19. In the present embodiment, the current sensor 7 is preferably a Rogowski type current sensor. The output current waveform measured by the Rogowski type current sensor has less noise than the output current waveform measured by a winding type current sensor. Therefore, the phase difference can be accurately measured and controlled by using the Rogowski type current sensor 7.

The output current waveform of the current sensor 7 is the waveform of the current flowing through the LCR circuit 5, and this is the current waveform after feedback. An output voltage Vout of the rectangular wave output from the transistor 19 and the output current of a sinusoidal wave flowing through the heating coil are output.

The output current waveform after the feedback is input to the phase comparator 12, the output current waveform and the above-described reference waveform are compared, and the phase difference therebetween is output from the phase comparator 12.

The high-frequency heating device 1 according to the present embodiment can control the drive frequency of the LCR circuit 5, and thus can reduce output fluctuations. The suppression of the output fluctuation by the high-frequency heating device 1 is extremely effective for the crystal growth of a high-melting point compound for which precise temperature distribution control is required.

Basket

The high-frequency heating device 1 according to the present embodiment includes a basket (not illustrated). The basket is a coolable container (cold container) having a cylindrical space inside, and the raw material can be disposed inside the basket. For example, a cooling path (not illustrated) through which cooling water flows is disposed inside the basket, and the basket is cooled by the cooling water flowing through the cooling path. The basket is made of a material having a high thermal conductivity. Examples of the material of the basket include copper, silver, aluminum, and iron. The basket is made of a material having a high thermal conductivity, and thus the basket cools the raw material disposed inside the basket.

The raw material is heated by the heating coil 51 and melted, but the temperature is low in the vicinity of the water-cooled basket, and therefore the melt in which the raw material is melted is solidified and sintered. The sintered body (skull) holds the melt. By controlling the frequency of the high-frequency voltage applied to the heating coil 51 disposed outside the basket, the temperature of the melt of the raw material is adjusted.

Rod

The high-frequency heating device 1 according to the present embodiment preferably includes a rod (not illustrated). The rod is moved in the opposite direction to the melt to grow the crystal. The rod is provided so that one end thereof can be inserted into the basket from above. The one end of the rod is provided with a seed crystal, which is arranged in the center of the heating coil 51 in the horizontal plane. The rod is movable relative to the basket from the one end side to the other end side of the rod.

Since the temperature of the melt is controlled to be near the melting point at the center of the basket by the high-frequency heating device 1, the seed crystal is pulled upward by the rod, whereby the melt is cooled and crystal growth progresses, and a crystal is produced. The pulling speed (moving speed) of the rod is, for example, 0.1 to 100 (mm/hour). The pulling speed is preferably 1 to 50 (mm/hour). The pulling speed is more preferably 3 to 20 (mm/hour).

Raw Material

The raw material is a high-melting point compound, for example, a high-melting point oxide such as gallium oxide ($\beta$-$Ga_2O_3$), gadolinium aluminum gallium garnet ($Gd_3(Al, Ga)_5O_{12}$), lithium tantalate ($LiTaO_3$), lithium niobate ($LiNbO_3$), or yttrium oxide ($Y_2O_3$). The high-melting point oxide may include high-melting point oxides containing various elements in addition to the above.

As described above, since oxides have a large value of the resistivity $\rho$, it is necessary to apply a high frequency f for heating in a case where the raw material is oxides. However, since the high-frequency heating device 1 can output the frequency f of several hundred kHz to the 10 MHz order, it is possible to heat the raw material of oxides. Further, since the high frequency f can be output, the diameter of the melt inside the raw material body can be increased, and the diameter of the crystal can be increased.

Further, since the high-frequency heating device 1 can adjust the frequency, the temperature of the melt in the vicinity of the seed crystal can be set to a temperature near the melting point thereof, and the crystal growth can be advanced.

Control Device

The high-frequency heating device 1 may include a control device (not illustrated). The control device controls various operations of the high-frequency heating device 1. The control device controls, for example, the pulling speed of the rod, the cooling capacity of the basket, and the like.

Rotation Mechanism

The high-frequency heating device 1 preferably further includes a rotation mechanism (not illustrated) that rotates at least one of the rod and the raw material about the central axis of the rod in the extending direction as a rotation axis. The rotation mechanism rotates the rod relative to the raw material, thereby reducing the non-uniformity of the temperature distribution in the device and the temperature distribution in the melt.

Operation

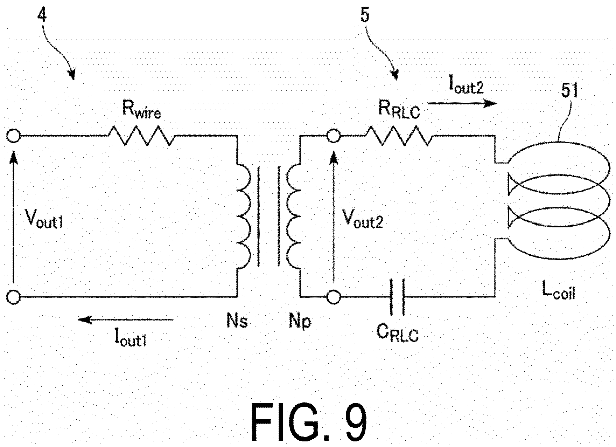

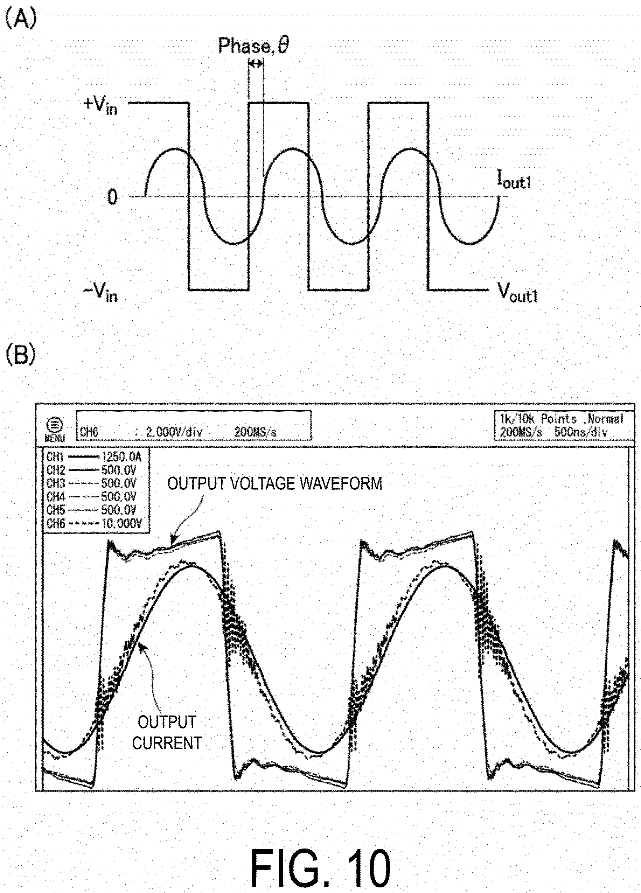

Here, the operation of the frequency control of the high-frequency heating device 1 will be described with reference to FIGS. 7, 9, and 10. FIG. 9 is a diagram schematically illustrating a circuit including a part of the circuit of the inverter unit 4, the LCR circuit 5, and the heating coil 51. FIG. 10(A) is a conceptual diagram for explaining the phase difference between the output current waveform and the reference waveform, and FIG. 10(B) is a waveform diagram illustrating an example of the output current waveform and the output voltage waveform.

As illustrated in FIG. 9, to the LCR circuit 5, a high-frequency voltage $V_{out1}$ (high-frequency rectangular wave) of the drive frequency output from the transistor 19 of the inverter unit 4 is applied. When the high-frequency rectangular wave is applied to the LCR circuit 5, an induced voltage $V_{out2}$ is generated in the LCR circuit 5, causing a high-frequency sinusoidal current $I_{out2}$ to flow through the heating coil 51. This is because the harmonics of the rectangular wave of the high-frequency voltage is filtered by the LCR circuit 5, and only a sinusoidal wave of the frequency of the rectangular wave, which is the fundamental wave, remains. The high-frequency sinusoidal current $I_{out2}$ is inputted to the current sensor 7, and the current sensor 7 outputs the output current waveform.

As illustrated in FIG. 10(A), when the output current waveform $I_{out1}$ and the high-frequency voltage waveform (reference waveform) generated by the arbitrary waveform generator 16 are inputted to the phase comparator 12, a voltage (output voltage waveform) corresponding to the phase difference $\theta$ between the output current waveform and the reference waveform is output from the phase comparator 12. When the voltage corresponding to the phase difference is applied to the low-pass filter 13, converted into a digital signal by the A/D converter 14, and inputted to the computer 15, the computer 15 detects the phase difference between the high-frequency current (output current waveform) and the output voltage waveform. The output current waveform and the output voltage waveform are illustrated as in FIG. 10(B), for example.

Further, the computer 15 compares the detected phase difference with the set threshold value, and when the phase difference crosses the threshold value, updates the drive frequency by a certain frequency variation amount, and inputs a signal for generating the updated drive frequency to the arbitrary waveform generator 16. The arbitrary waveform generator 16 generates a rectangular wave of the updated frequency, and controls the gate voltage of the transistor 19 of the inverter unit 4. The transistor 19 outputs the high-frequency voltage of the updated drive frequency and applies it to the LCR circuit 5.

The feedback control is performed as described above. That is, in at least one of the melting step and the crystal growth step, the drive frequency of the high-frequency voltage applied to the LCR circuit 5 is controlled based on the phase difference between the high-frequency voltage and the high-frequency current, or the phase difference between the gate voltage of the transistor that determines the frequency of the wave heating device and the high-frequency current. In this manner, the temperature distribution of the raw material melt is controlled.

In this way, the phase difference between the output current waveform and the output voltage waveform is controlled so as to fall within a predetermined range by feeding back the frequency of the high-frequency magnetic field, thereby enabling stable heating control.

Further, the high-frequency heating device is configured by the phase difference detection unit that detects a phase difference between a high-frequency voltage and a high-frequency current, the frequency control unit that compares the detected phase difference with a threshold value and feeds back the comparison result to the heating frequency, the inverter unit that generates the frequency-controlled high-frequency voltage, and the LCR circuit that performs induction heating, and thus the frequency can be controlled by detecting the phase difference between the high-frequency voltage and the high-frequency current.

Further, in the high-frequency heating device, the gate voltage of the transistor of the inverter unit is controlled by software using the seed frequency control unit including a computer to generate a high frequency, thereby realizing stable feedback control at low cost.

As an example of a preferred embodiment of the present invention, an example, in which the drive frequency is controlled based on the phase difference between the high-frequency voltage applied to the LCR circuit and the high-frequency current flowing through the LCR circuit in the crystal growth step of the crystal production method using gallium oxide as a raw material, will be described.

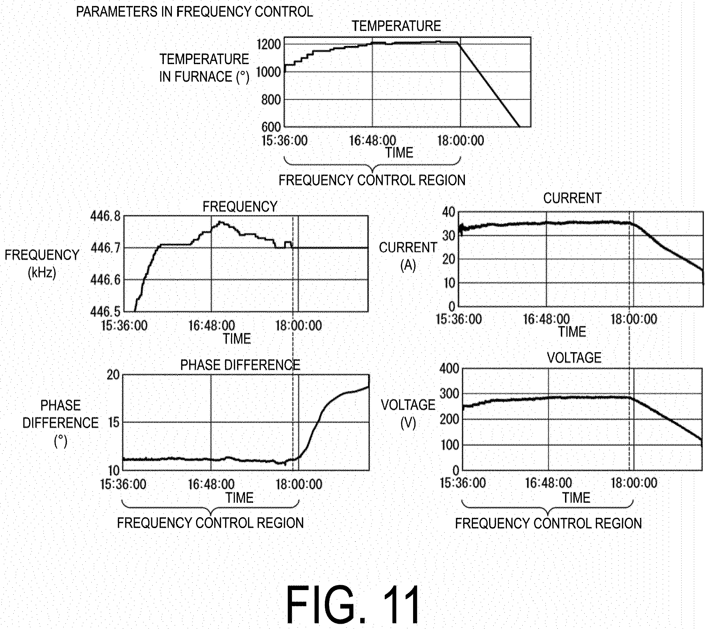

FIG. 11 illustrates the changes over time in the temperature, the drive frequency, the phase difference between the high-frequency voltage and high-frequency current, the high-frequency voltage applied to the LCR circuit, and the high-frequency current flowing through the LCR circuit during the crystal growth step in which the drive frequency is controlled based on the above phase difference.

By controlling the drive frequency, the voltage applied to the LCR circuit and the current flowing therethrough are controlled, and a stable crystal growth process can be realized.

Next, in the raw material melting step of the crystal production method using gallium oxide as the raw material, a process of controlling the drive frequency based on the phase difference between the high-frequency voltage applied to the LCR circuit and the high-frequency current flowing through the LCR circuit will be described.

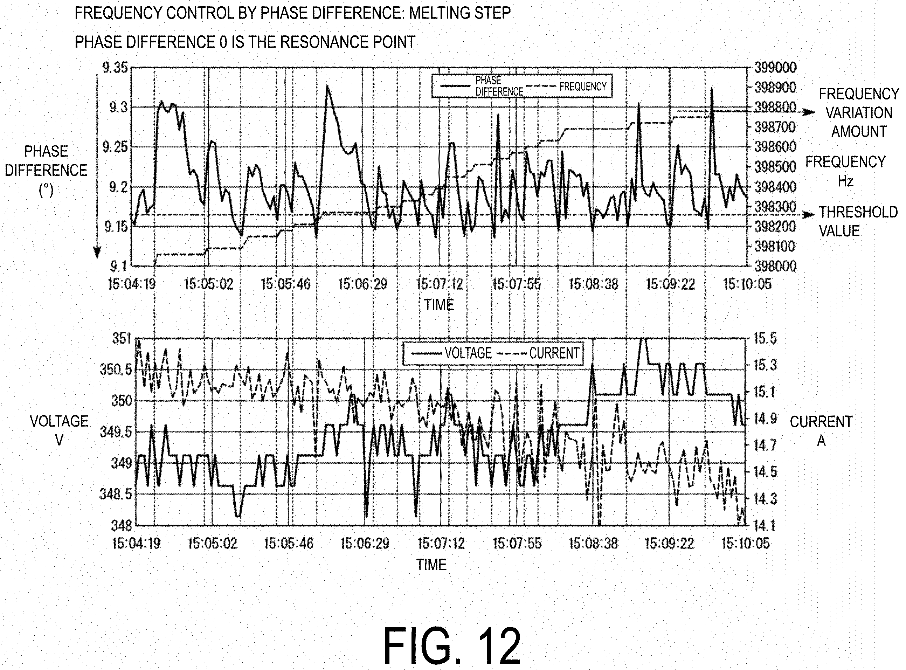

FIG. 12 illustrates an example in which the drive frequency is controlled when the lower limit threshold value of the phase difference is set to 9.17 degrees. In this step, the lower limit threshold value is set to appropriately suppress the transistor from being damaged due to an overcurrent flowing therethrough. At this time, the phase difference fluctuates in the range of 9.15 to 9.33 degrees, and when the phase difference falls below the lower limit threshold value of 9.17, the drive frequency is changed to the high-frequency side by a frequency variation amount of 30 Hz.

The high-frequency current flowing through the LCR circuit contains noise, but decreases from 15.3 A to 14.1 A, and the high-frequency voltage applied to the LCR circuit contains noise, but increases from 349 V to 350.5 V. Since the fluctuation amount of the current and voltage is smaller than the change in the phase difference, the temperature distribution can be controlled more precisely by using the method of monitoring the phase difference to control the frequency than by current/voltage control.

Next, in the crystal growth step of the crystal production method using gallium oxide as a raw material, the process of controlling the drive frequency based on the phase difference between the high-frequency voltage applied to the LCR circuit and the high-frequency current flowing through the LCR circuit will be described.

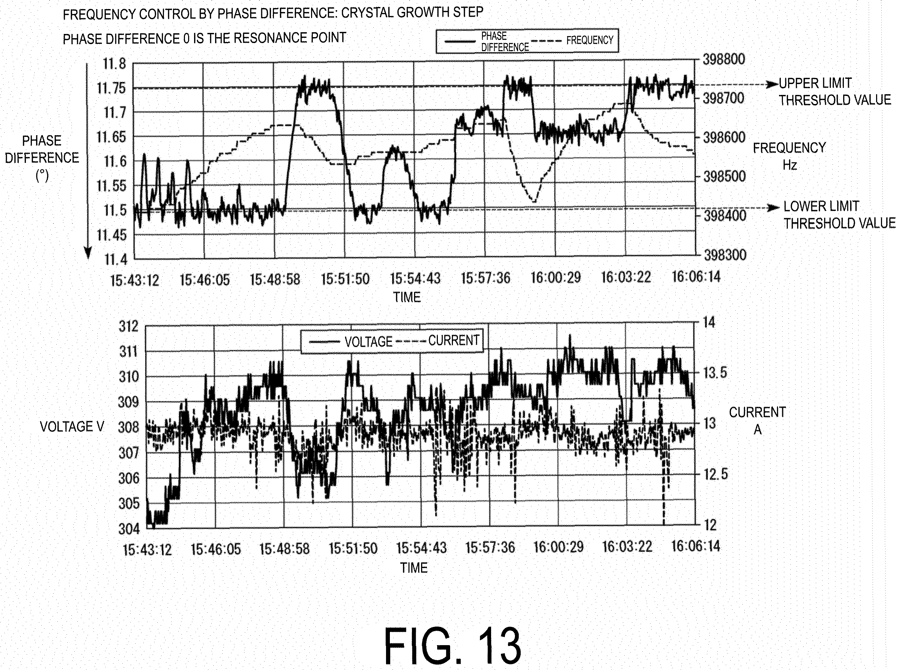

In FIG. 13, the lower limit threshold value is set to 11.5 degrees and the upper limit threshold value is set to 11.75 degrees, and the drive frequency is increased when the phase difference is lower than the lower limit threshold value and the drive frequency is decreased when the phase difference is higher than the upper limit threshold value, thereby controlling the drive frequency so that the temperature becomes optimal. The frequency variation amount at this time is 10 Hz.

The current and the voltage include a lot of noise, whereas the phase difference changes relatively stably.

FIG. 14 is a diagram illustrating the relationship between the coil position and the defect density. The coil position indicates the difference in height from the upper end of the melt to the upper end of the coil, and the coil position becomes lower as the value increases. The defect density is a value calculated from the dislocation density measured by an etch pit method.

In FIG. 14, when the coil position is smaller than 5 mm, the value is as high as $1 \times 10^4$ cm$^{-2}$ or more, but when the coil position is larger than 5 mm, the value is as low as $1 \times 10^4$ cm$^{-2}$ or less. Further, the defect density tends to decrease as the position is lower.

It is apparent that the present invention is not limited to the embodiments described above, and that many modifications and combinations can be made by those skilled in the art within the technical idea of the present invention.

Industrial Applicability

The production device and the production method of the present invention are useful for crystal growth and are used for production of various seed crystals.

Reference Signs List

1 High-frequency heating device
2 Phase difference detection unit
3 Frequency control unit
4 Inverter unit
5 LCR circuit
7 Current sensor
12 Phase comparator
13 Low-pass filter
14 A/D converter
15 Computer
16 Arbitrary waveform generator
17 Thyristor regulator
18 Step-up transformer
19 Transistor
51 Heating coil
101 Holding table
102 Cooling mechanism (cold container: basket)
103 High-frequency induction-heating coil
104 Growth chamber
105 Exhaust pipe

106 Gas introduction pipe
151 Raw material body
152 Melted body
161 Seed crystal
162 Holding rod
201 Holding table
202 Cooling mechanism
203 High-frequency induction-heating coil
204 Growth chamber
205 Exhaust pipe
206 Gas introduction pipe
251 Raw material body
261 Seed crystal

**Claims**

1. A production device for a crystal, comprising at least a high-frequency induction-heating coil, the production device being configured to form a molten zone of a raw material solution by using high-frequency induction heating, and produce a crystal by crystal growth in a longitudinal direction of the molten zone, wherein a width of the molten zone satisfies Formula (1) below: [Formula 1]

$$\frac{D}{2} > 5.03\sqrt{\rho/\mu F} \quad \cdots (1)$$

wherein D represents the width (cm) of the molten zone, $\rho$ represents a resistivity ($\mu\Omega$cm) of the raw material solution, $\mu$ represents a relative permeability of the raw material solution, and F represents a frequency (Hz) of the high-frequency induction-heating coil.

2. The production device according to claim 1, wherein an upper end of the high-frequency induction-heating coil is disposed at a depth position of 5 mm or less from a liquid surface of the raw material melt, and the production device comprises a positional relationship holding unit that performs the crystal growth while maintaining a positional relationship between the depth position and the upper end.

3. The production device according to claim 2, wherein the positional relationship holding unit comprises a movable unit for the high-frequency induction-heating coil or a movable unit for the molten zone.

4. The production device according to claim 1, further comprising a cold container used in a skull melt method, wherein the width of the molten zone is an inner dimension of the cold container, and the crystal growth is performed by a melt growth method using a melt directly heated by high frequency waves.

5. The production device according to claim 1, wherein the raw material solution contains Ga.

6. A production method for a crystal, the method forming a molten zone of a raw material solution by using high-frequency induction heating with a high-frequency induction-heating coil, and producing a crystal by crystal growth in a longitudinal direction of the molten zone, wherein the crystal growth is performed so as to satisfy Formula (1) below: [Formula 2]

$$\frac{D}{2} > 5.03\sqrt{\rho/\mu F} \quad \cdots (1)$$

wherein D represents the width (cm) of the molten zone, $\rho$ represents a resistivity ($\mu\Omega$cm) of the raw material solution, $\mu$ represents a relative permeability of the raw material solution, and F represents a frequency (Hz) of the high-frequency induction-heating coil.

7. The production method according to claim 6, wherein an upper end of the high-frequency induction-heating coil is disposed at a depth position of 5 mm or less from a liquid surface of the raw material melt, and the crystal growth is performed while maintaining a positional relationship between the depth position and the upper end.

8. The production method according to claim 7, wherein the crystal growth is performed while moving the high-frequency induction-heating coil or the molten zone.

9. The production method according to claim 6, wherein the crystal growth is performed by a melt growth method using a melt directly heated by high frequency waves.

10. The production method according to claim 6, wherein the raw material solution contains Ga.

$$\delta = 5,03 \times (\rho / (\mu \times F)) 1/2 \quad \cdots \text{Formula (4)}$$

# FIG. 1

106 ~

162 ~

~104

161 ~

102

103

151~

~101

~105

# FIG. 2A

106 ~
162 ~
~ 104
161 ~
102
103
152
151
~ 101
~ 105

# FIG. 2B

FIG. 2C

FIG. 2D

FIG. 2E

FIG. 3

FIG. 4A

206

204

251

202

203

261

252

201

205

# FIG. 4B

FIG. 4C

FIG. 4D

```
              ┌─────────┐
              │  START  │
              └─────────┘
                   │
        ┌──────────────────────┐
        │                      │ ～  S301
        │  WEIGHT MEASUREMENT  │
        │                      │
        └──────────────────────┘
                   │
        ┌──────────────────────┐
        │                      │ ～  S302
        │ DIAMETER CALCULATION │
        │                      │
        └──────────────────────┘
                   │
        ┌──────────────────────┐
        │ MAGNETIC FIELD OUTPUT│ ～  S303
        │       CONTROL        │
        └──────────────────────┘
                   │
              ┌─────────┐
              │   END   │
              └─────────┘
```

# FIG. 5

| | | | |
|---|---|---|---|
| 301 | WEIGHT MEASUREMENT UNIT | DIAMETER CALCULATION UNIT | 302 |
| 303 | MAGNETIC FIELD OUTPUT CONTROL UNIT | HIGH-FREQUENCY POWER SUPPLY | 304 |

# FIG. 6

HIGH-FREQUENCY HEATING DEVICE 1

FIG. 7

(A)

(B)

FIG. 8

FIG. 9

(A)

Phase, $\theta$

$+V_{in}$

0 ............................................ $I_{out1}$

$-V_{in}$ ................................. $V_{out1}$

(B)

| MENU | CH6 | : 2.000V/div | 200MS/s | 1k/10k Points ,Normal 200MS/s 500ns/div |

| CH1 | 1250.0A |
| CH2 | 500.0V |
| CH3 | 500.0V |
| CH4 | 500.0V |
| CH5 | 500.0V |
| CH6 | 10.000V |

OUTPUT VOLTAGE WAVEFORM

OUTPUT CURRENT

# FIG. 10

PARAMETERS IN FREQUENCY CONTROL

FIG. 11

FREQUENCY CONTROL BY PHASE DIFFERENCE: MELTING STEP

PHASE DIFFERENCE 0 IS THE RESONANCE POINT

FIG. 12

FREQUENCY CONTROL BY PHASE DIFFERENCE: CRYSTAL GROWTH STEP
PHASE DIFFERENCE 0 IS THE RESONANCE POINT

FIG. 13

EP 4 671 418 A1

Example (Ga$_2$O$_3$)

FIG. 14

FIG. 15

## INTERNATIONAL SEARCH REPORT

| International application No. |
| --- |
| **PCT/JP2024/006896** |

| A. CLASSIFICATION OF SUBJECT MATTER |
| --- |
| *C30B 13/20*(2006.01)i<br>FI: C30B13/20 |
| According to International Patent Classification (IPC) or to both national classification and IPC |

| B. FIELDS SEARCHED |
| --- |
| Minimum documentation searched (classification system followed by classification symbols)<br>   C30B13/20, C30B11/00 |
| Documentation searched other than minimum documentation to the extent that such documents are included in the fields searched<br>   Published examined utility model applications of Japan 1922-1996<br>   Published unexamined utility model applications of Japan 1971-2024<br>   Registered utility model specifications of Japan 1996-2024<br>   Published registered utility model applications of Japan 1994-2024 |
| Electronic data base consulted during the international search (name of data base and, where practicable, search terms used) |

### C. DOCUMENTS CONSIDERED TO BE RELEVANT

| Category* | Citation of document, with indication, where appropriate, of the relevant passages | Relevant to claim No. |
| --- | --- | --- |
| Y | US 5900060 A (CERMET, INC.) 04 May 1999 (1999-05-04)<br>   column 6, line 62 to column 12, line 62, fig. 2 | 1, 3-6, 8-10 |
| A | | 2, 7 |
| Y | JP 11-130581 A (NIPPON STEEL CORPORATION) 18 May 1999 (1999-05-18)<br>   paragraphs [0012], [0016]-[0022] | 1, 3-6, 8-10 |
| A | | 2, 7 |
| X | JP 2015-218076 A (SHIN-ETSU HANDOTAI CO., LTD.) 07 December 2015 (2015-12-07)<br>   paragraphs [0089]-[0094], fig. 1-4 | 1-3, 6-9 |
| Y | | 5, 10 |
| A | | 4 |
| A | 干川圭吾, アドバンストエレクトロニクスⅠ－4　バルク結晶成長技術, 20 May 1994, non-official translation (HOSHIKAWA, Keigo. Advanced electronics I-4. Bulk crystal growth technology.)<br>   p. 21 | 1-10 |

| ✓ Further documents are listed in the continuation of Box C. | ✓ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **17 May 2024** | **04 June 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT

| International application No. |
| --- |
| **PCT/JP2024/006896** |

### C. DOCUMENTS CONSIDERED TO BE RELEVANT

| Category* | Citation of document, with indication, where appropriate, of the relevant passages | Relevant to claim No. |
| --- | --- | --- |
| Y | JP 2005-239517 A (NIPPON LIGHT METAL COMPANY, LTD.) 08 September 2005 (2005-09-08)<br>    paragraph [0016] | 5, 10 |
| A | | 1-4, 6-9 |

Form PCT/ISA/210 (second sheet) (July 2022)

43

## INTERNATIONAL SEARCH REPORT
### Information on patent family members

International application No.

**PCT/JP2024/006896**

| Patent document cited in search report | | | Publication date (day/month/year) | Patent family member(s) | Publication date (day/month/year) |
|---|---|---|---|---|---|
| US | 5900060 | A | 04 May 1999 | (Family: none) | |
| JP | 11-130581 | A | 18 May 1999 | (Family: none) | |
| JP | 2015-218076 | A | 07 December 2015 | (Family: none) | |
| JP | 2005-239517 | A | 08 September 2005 | (Family: none) | |

Form PCT/ISA/210 (patent family annex) (July 2022)

**REFERENCES CITED IN THE DESCRIPTION**

**Patent documents cited in the description**

- JP 2006312571 A
- US 4049384 A
- JP S602876 A
- JP 2017061396 A
- JP 2018191426 A

**Non-patent literature cited in the description**

- **HIDEO AIDA et al.** Growth of β-Ga2O3 single crystals by the Edge-Defined, Film Fed Growth Method. *Jpn. Journal of Applied Physics*, 2008, vol. 47 (11), 8506-8509